# EUROPEAN PATENT APPLICATION

(11) **EP 1 742 349 A1**
(43) Date of publication of application: **10.01.2007**
(21) Application number: 05729368.0
(22) Date of filing: 06.04.2005
(51) Int. Cl.: H03B 5/30, H03H 9/145, H04L 27/12

(54) **OSCILLATION CIRCUIT AND ELECTRONIC DEVICE**

(30) Priority: 06.04.2004 JP 2004112296
(71) Applicant: SEIKO EPSON CORPORATION, Shinjuku-ku, Tokyo 163-0811 (JP)
(72) Inventor: OGISO, Hiroyuki, a-shi, Nagano 3928502; (JP)
(74) Representative: Siegert, Georg
(86) International application number: PCT/JP2005/007185
(87) International publication number: WO 2005/099083

(57) **Abstract**

There are provided an oscillation circuit that, even when the frequency band is changed, can switch between frequency bands without causing no discontinuity in output phase shift as well as can maintain good frequency accuracy and frequency shift accuracy, and an electronic device having the oscillation circuit built therein.

An oscillation circuit for solving the abovementioned problem includes a SAW resonator 10 having a pair of reflectors 14 provided on a piezoelectric substrate and a pair of IDTs 16 that are provided in parallel between the pair of reflectors 14 and include a comb tooth-shaped electrode 18; an inverter 20 to which the pair of IDTs 16 are connected in parallel; and a switching means 22 that is provided between each of the pair of comb tooth-shaped electrodes 18 composing either IDT 16 of the pair of IDTs 16 and the inverter 20, switches between the input side and output side of the inverter 20 to be connected to each of the pair of electrodes 18, and connects the electrodes and the amplifier circuit.

## Description

### Technical Field

The present invention relates to an oscillation circuit and an electronic device including the oscillation circuit. The invention particularly relates to an oscillation circuit that is preferably applied to a device that conducts communications by the FSK (Frequency Shift Keying) method, and an electronic device having the oscillation circuit built therein.

### Background Art

The communication method using the FSK method has heretofore been known as a method for communicating digital signals. The FSK method refers to a modulation method that discretely changes an instantaneous frequency of a carrier wave corresponding to a digital signal of, for example, 0 or 1. FSK makes it possible to perform modulation while keeping an amplitude variation constant, and is less affected by a level change or noise. FSK is characterized in that its circuit configuration is simple and that it has a wider bandwidth than ASK (Amplitude Shift Keying) and PSK (Phase Shift Keying).

As mentioned above, the communication method using the FSK method has a high use value, and a variety of oscillation circuits and oscillators using this type of communication method have been proposed. For example, the oscillation circuits and the oscillators proposed in patent literature 1 and patent literature 2 also use a communication method using the FSK method.

The oscillator described in patent literature 1 has a plurality of SAW resonators with different resonant frequencies provided on one piezoelectric substrate, and oscillation circuits of the number corresponding to the number of the SAW resonators provided on one semiconductor IC substrate, wherein the oscillation circuits are connected to a switching circuit.

The oscillator thus configured causes a switching circuit to activate according to a frequency band to be used, and selects an oscillation circuit connected to a SAW resonator corresponding to a desired frequency band to let the selected circuit oscillate.

The oscillation circuit described in patent literature 2 has therein two types of SAW filters with different frequency bands to be passed through, and a switching circuit located on the output side of the SAW filters. The oscillation circuit constitutes a feedback circuit including an amplifier and a fixed phase shifter.

In such an oscillation circuit, it is possible to select only a frequency of a required frequency band by switching an SAW filter to be connected to using the switching circuit.
[Patent literature 1] Japanese Patent No. 2925158
[Patent literature 2] JP-A- 2004-40421

### Disclosure of the Invention

According to the oscillator and the oscillation circuit described in the abovementioned patent literature 1 and patent literature 2, it is possible to provide an oscillator and an oscillation circuit corresponding to a desired frequency band.

However, the oscillator and the oscillation circuit described in the abovementioned patent literature 1 and patent literature 2 both correspond to a required frequency band by including a plurality of SAW resonators or SAW filters with different frequency bands and switching between those resonators or filters depending on a frequency band to be used. Consequently, when the SAW resonator or SAW filter is switched, there may occur instantaneous interruption of the oscillation frequency or a discontinuity in output phase shift due to an electrical connection, a difference in phase shift between the SAW resonators or SAW filters, or the like, resulting in an error at the time of switching. In particular, these problems have a great effect when conducting high-speed communications. The oscillation circuit described in patent literature 1 also has a problem that it is not possible to obtain frequency accuracy or phase shift accuracy in each SAW resonator. This is because the oscillation circuit is configured to include a plurality of SAW resonators according to different specifications in one circuit.

An object of the invention is to solve the abovementioned problems to provide an oscillation circuit that, even when the frequency band is changed, can eliminate a discontinuity in output phase shift accompanying switchover of the frequency band as well as can maintain good frequency accuracy and frequency shift accuracy, and an electronic device having the oscillation circuit built therein.

To attain the abovementioned object, it is conceivably preferable that either of SAW resonators for switching between frequency bands is used as a reference and a phase at the time of switching can immediately be made to match with a signal from the SAW resonator used as a reference. Further, in order to maintain good frequency accuracy or frequency shift accuracy, it is conceivably necessary to reduce mutual interference between the SAW resonators for switching.

An oscillation circuit according to the present invention includes a SAW resonator having a pair of reflectors provided on a piezoelectric substrate and a pair of IDTs that are provided in parallel between the pair of reflectors and include a comb tooth-shaped electrode; an amplifier circuit to which the pair of IDTs are connected in parallel; and a switching circuit that is provided between each of the pair of comb tooth-shaped electrodes composing either IDT of the pair of IDTs and the amplifier circuit, switches the input side and output side of the amplifier circuit to be connected to each of the pair of comb tooth-shaped electrodes, and connects the electrodes and the amplifier circuit.

According to the oscillation circuit thus configured, fixing connection of I/O signals to either IDT of the SAW resonator included in the circuit and making connection of I/O signals to the other IDT switchable by the switching circuit allows a plurality of oscillation types in different modes, for example, achievement of S0 mode and A0 mode by one SAW resonator. This makes it possible to produce a plurality of oscillations of different frequency bands by one SAW resonator. Since it is possible to switch between the frequency bands by one SAW resonator, there is no need for tuning of the frequency accuracy and frequency shift accuracy. This makes it easy to adjust the frequency accuracy and the frequency shift accuracy, allowing maintenance of good frequency accuracy and frequency shift accuracy. Further, letting either IDT of the pair of IDTs always produce an oscillation as an oscillation unit for producing a reference oscillation allows a reference oscillation unit to be provided in one oscillator. As a result, even when switching between I/O signals to the other IDT, it is possible to immediately match the phase with an oscillation produced by the one IDT, eliminating a discontinuity in output phase. Further, providing a single SAW resonator in a circuit and making the frequency band switchable by the single SAW resonator allows significant promotion of size-reduction and cost-reduction of the oscillation circuit.

It is preferable that in the oscillation circuit thus configured, the pair of IDTs be configured such that the crossing widths between the comb tooth-shaped electrodes are identical.

According to the abovementioned configuration, it is possible to synchronize oscillations produced by the mutual IDTs as well as to improve the frequency accuracy and the frequency shift accuracy. This is because the IDT in the SAW resonator makes a slight change to the frequency to be outputted by changing the crossing width. Therefore, adjusting (controlling) the crossing width of the comb tooth-shaped electrodes composing the IDT allows achievement of a desired frequency accuracy.

It is preferable that an electronic device for attaining the abovementioned object have the oscillation circuit thus configured built therein.

Configuring an electronic device as mentioned above allows achievement of a similar effect to that achieved by the abovementioned oscillation circuit, thus providing a compact, inexpensive, and accurate oscillator.

### Brief Description of the Drawings

Fig. 1 is a block diagram showing an embodiment according to an oscillation circuit of the present invention.
Fig. 2 is a block diagram showing a configuration of a SAW resonator mounted on the oscillation circuit of the invention.
Fig. 3 is figure showing oscillation modes of the SAW resonator mounted on the oscillation circuit of the invention.
Fig. 4 is a graph showing changes in frequency difference made when changes are made in the crossing width of comb tooth-shaped electrodes of the SAW resonator mounted on the oscillation circuit of the invention.
Fig. 5 is a block diagram showing a configuration of an electronics device having the oscillation circuit of the invention built therein.

### Best Mode for Carrying Out the Invention

An embodiment according to an oscillation circuit and an electronic device having the oscillation circuit built therein of the present invention will now be described with reference to the accompanying drawings. The embodiment disclosed below is an embodiment according to the oscillation circuit and the electronic device of the invention. The invention contains various embodiments unless the main part thereof is changed.

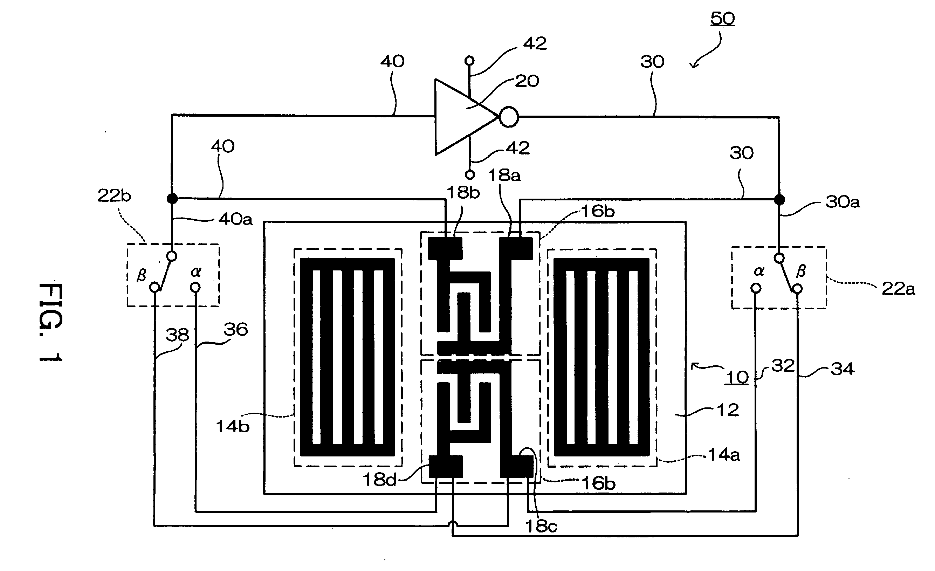

First, a schematic configuration of an oscillation circuit according to this embodiment is described referring to Fig. 1. An oscillation circuit 50 according to the embodiment basically includes a SAW resonator 10, an inversion amplifier (hereinafter referred to as inverter) 20 serving as an amplifier circuit for transmitting a signal to the SAW resonator 10, and a power supply 42 connected to the inverter 20. The SAW resonator 10 and the inverter 20 compose a feedback circuit.

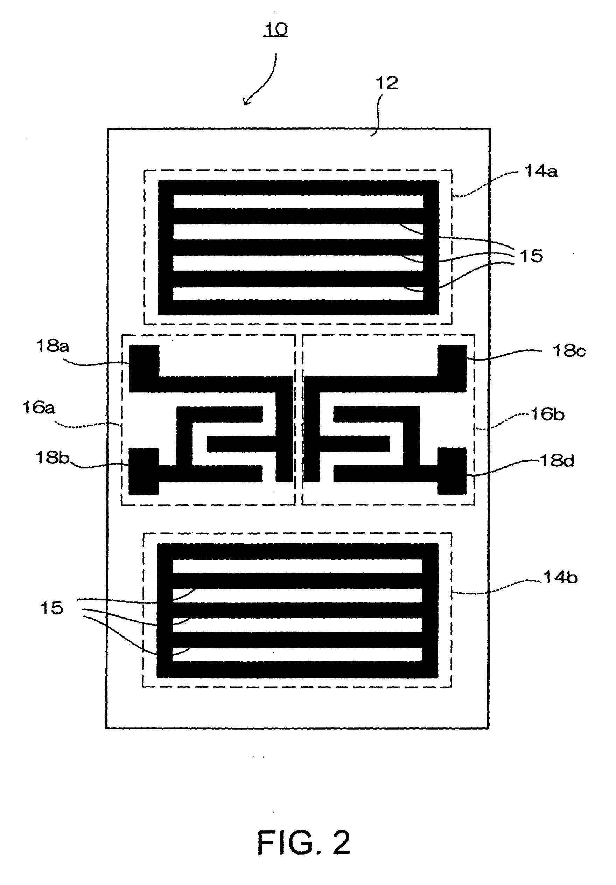

In the embodiment, as shown in Fig. 2, the SAW resonator 10 includes a piezoelectric substrate 12, a pair of reflectors 14a and 14b provided on one main surface of the piezoelectric substrate 12, and a conductive pattern forming a plurality of comb tooth-shaped electrodes 18 (18a, 18b, 18c, and 18d) provided between the pair of reflectors 14a and 14b.

The piezoelectric substrate 12 may include a piezoelectric monocrystal, such as crystalline quartz, lithium tantalate (LiTaO₃), tetraboric acid lithium (Li₂B₂O₇), or lithium niobate (LiNbO₃), a sapphire substrate having a ZnO thin film, or the like.

The reflector 14 provided on the piezoelectric substrate 12 and the conductive pattern forming the comb tooth-shaped electrodes 18 may be formed by forming a conductive metal, such as gold, copper, or aluminum, into a thin film by vapor deposition, sputtering, or the like and patterning the formed thin film by etching (for example, photolithography).

The reflector 14 provided on the piezoelectric substrate 12 of the SAW resonator 10 mounted on the oscillation circuit 50 according to the embodiment is a pattern formed in a ladder-shape. On the piezoelectric substrate 12, an electrode section 15 in a ladder-shape is arranged such that it is perpendicular to the propagation direction of an elastic surface wave. The reflector 14 is provided in a pair on the piezoelectric substrate 12. The pair of reflectors 14a and 14b are provided along the propagation direction of an elastic surface wave.

The comb tooth-shaped electrodes 18 compose one IDT (interdigital transducer) 16 by engaging an electrode serving as an input side of a signal with an electrode serving as an output side of a signal.

The IDT 16 is provided in a pair in parallel between the reflectors 14a and 14b on the piezoelectric substrate 12. Specifically, a pair of IDTs 16a and 16b are provided between the reflectors 14a and 14b on the piezoelectric substrate 12 in a line symmetry using a direction along the propagation direction of an elastic surface wave, which is the direction of providing the reflectors 14a and 14b, as an axis. When providing the IDT16, an insulator is provided along the propagation direction of an elastic surface wave between the pair of IDT 16a and IDT 16b. A comb tooth-shaped electrode portion of the comb tooth-shaped electrode 18 is disposed to be perpendicular to the propagation direction of an elastic surface wave.

In the SAW resonator 10 thus configured, reversing a signal to be inputted to the comb tooth-shaped electrode 18a through 18c composing the IDTs 16a and 16b and a signal to be outputted to those electrodes allows production of an oscillation in different modes (SO mode and AO mode in the embodiment). This makes it possible to produce oscillations of a plurality of frequency bands with the single SAW resonator 10. Further, since it is possible to switch between frequency bands by the single SAW resonator 10, there is no need for producing an oscillation while tuning the respective frequency accuracies and frequency shift accuracies of a plurality of SAW resonators. This makes it easy to adjust the frequency accuracy and the frequency shift accuracy, allowing maintenance of good frequency accuracy and frequency shift accuracy.

Letting either IDT 16 of the pair of IDT 16s (16a and 16b) always produce an oscillation as an oscillating unit for producing a reference oscillation means that the single SAW resonator 10 has a reference oscillation unit therein. Consequently, even when switching between I/O signals to the other IDT 16, it is possible to immediately match the phase with the one IDT 16 serving as a reference oscillation unit, causing no discontinuity in output phase.

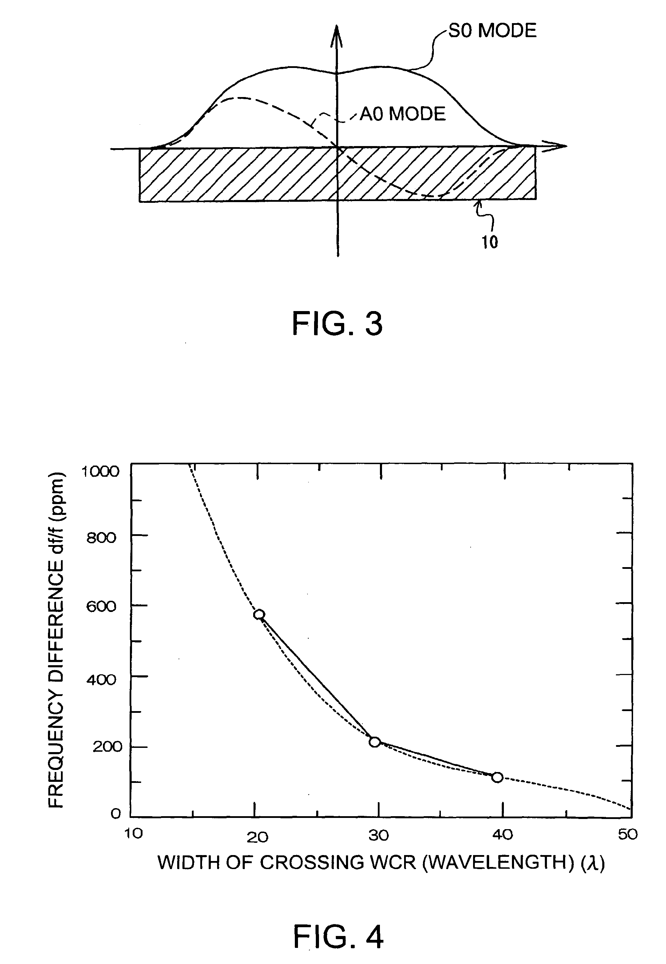

In the embodiment, SO mode and AO mode refer to the oscillation patterns as shown in Fig. 3. That is, S0 mode is a line symmetry mode considered a basic mode; A0 mode is a point symmetry mode considered a high order mode.

Described below is a configuration of an oscillation circuit having the SAW resonator thus configured mounted thereon (refer to Fig. 1).

That is, the IDTs 16a and 16b composing the SAW resonator 10 are connected to the inverter 20 in parallel, and the switching circuit (switching means) 22 is provided between the IDT 16b and the inverter 20. This configuration allows reversing of I/O signals to the comb tooth-shaped electrodes 18 composing the IDT16.

Specifically, the configuration is as follows. When using the comb tooth-shaped electrode 18a of the IDT 16a as an input electrode, and the comb tooth-shaped electrode 18b as an output electrode, an input signal path 30 for inputting an input signal to the IDT 16a, which is an output signal from the inverter 20, is connected to the comb tooth-shaped 18a, and an output signal path 40 for outputting an output signal from the IDT 16a, which is an input signal to the inverter 20, is connected to the comb tooth-shaped electrode 18b.

Further, bifurcating the input signal path 30 and the output signal path 40 forms an input signal path 30a and an output signal path 40a, respectively. The input signal path 30a and the output signal path 40a are provided with a switching means 22 (22a and 22b, respectively) for enabling switching between α and β to select either of two lines of the S0 mode signal transmission path and the A0 mode signal transmission path.

The S0 mode signal transmission path and the A0 mode signal transmission path between which can be switched by the switching means 22, are each connected to the IDT 16b. The IDT 16b is configured so that an output side signal path and an input side signal path are connected to both the comb tooth-shaped electrodes 18c and 18d. That is, when connecting an input side S0 mode signal transmission path (input signal path) 32 at the time of selecting α to the comb tooth-shaped electrode 18c, an output side S0 mode signal transmission path (output signal path) 36 at the time of selecting α is connected to the comb tooth-shaped electrode 18d. In this case, an input side A0 mode signal transmission path (input signal path) 34 at the time of selecting β is connected to the comb tooth-shaped electrode 18d, and an output side A0 mode signal transmission path (output signal path) 38 at the time of selecting β is connected to the comb tooth-shaped electrode 18c.

With such a circuit configuration, it is possible to reverse I/O of a signal to the IDT 16b by switching between α and β by the switching means 22. Note that the switching means 22a and 22b must carry out switching between α and β in synchronization.

In the oscillation circuit thus configured, the IDT 16a connected to the input signal path 30 and the output signal path 40 makes no change in the phase of an elastic surface wave. This is because there is no switching between the comb tooth-shaped electrode 18a to which a signal is inputted and the comb tooth-shaped electrode 18c from which a signal is outputted.

On the other hand, the IDT 16b to which the input signal transmission path 30a and the output signal transmission path 40a are connected reverses the input side comb tooth-shaped electrode and the output side comb tooth-shaped electrode by switching between α and β by means of control by the switching means 22. This results in shifting the phase of an oscillated elastic surface wave by 90 °.

Therefore, when the switching means 22 is set to α, the comb tooth-shaped electrodes 18a and 18c become input side electrodes, an elastic surface wave emitted from the IDT 16a and one emitted from the IDT 16b have an identical phase, and thus the oscillation circuit produces an SO mode oscillation. On the other hand, when the switching means 22 is set to β, the comb tooth-shaped electrodes 18a and 18d becomes input side electrodes, an elastic surface wave emitted from the IDT 16a has an opposite phase to one emitted from the IDT 16b, and thus the oscillation circuit produces an A0 mode oscillation.

In this manner, the SAW resonator thus configured allows production of an oscillation in two modes with a single SAW resonator by controlling I/O of a signal to the comb tooth-shaped electrodes 18a through 18d.

The oscillation circuit 50 thus configured is configured so that I/O of a signal to the comb tooth-shaped electrodes 18a and 18b composing the IDT 16a is continuously carried out. This eliminates a possibility that even when reversing (switching) signals inputted and outputted to the IDT 16b, an oscillation produced by the SAW resonator or oscillation circuit may instantaneously be interrupted. This also prevents occurrence of a shift in output phase shift, which may be caused by such an interruption. This makes it possible to use the SAW resonator or oscillation circuit for high-speed communications or the like.

It is generally known that a set of comb tooth-shaped electrodes composing a SAW resonator make a change in oscillation frequency by changing the crossing width of the electrodes. Thus, the SAW resonator 10 mounted on the oscillation circuit 50 thus configured is designed so that the crossing width of the comb tooth-shaped electrodes 18 composing the IDT 16 is adjusted (controlled) according to a desired frequency accuracy. This allows adjustment of the frequency difference (frequency deviation), as shown in Fig. 4. According to Fig. 4, it can be seen that it is possible to adjust the frequency difference up to a practical use level by setting up the cross width. Note that the cross width of the comb tooth-shaped electrodes in the IDT 16a and that in the IDT 16b are configured to be identical. This allows tuning of oscillations produced by mutual IDTs as well as production of an oscillation in SO mode and AO mode.

In the oscillation circuit 50 thus configured, when connecting signal transmission paths to the SAW resonator 10, the input signal path 30 and the output signal path 40 are connected to the IDT 16a, while the signal transmission paths 30a and the output signal path 40a are connected to the IDT 16b. As a matter of course, the oscillation circuit 50 may be configured so that the input transmission path 30 and the output transmission path 40 are connected to the IDT 16b, while the input transmission path 30a and the output transmission path 40a are connected to the IDT 16a.

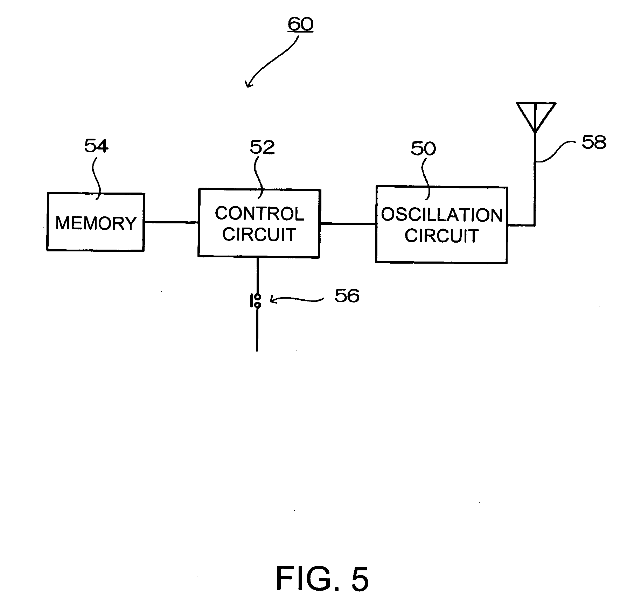

The oscillation circuit 50 thus configured can be built and used in a variety of electronic devices. For example, the oscillation circuit 50 can be built in an FSK oscillator (transmitter) 60 as shown in Fig. 5. The FSK oscillator 60 is configured to include a memory 54 for recording FSK data, an oscillation circuit 50 for producing an oscillation based on FSK data in the memory 54, a control circuit 52 for transmitting FSK data in the memory 54 to the oscillation circuit 50 as needed, a switch 56 for activating the control circuit, and an antenna 58 for emitting a signal to the outside.

The FSK oscillator 60 thus configured makes it possible to make the number of SAW resonators 10 to be mounted on the oscillation circuit 50 one. This can realize size-reduction and cost-reduction of a device. The FSK oscillator 60 thus configured can be used as, for example, a keyless oscillator for a car capable of keyless entry.

## Claims

1. An oscillation circuit comprising:
a SAW resonator having a pair of reflectors provided on a piezoelectric substrate and a pair of IDTs that are provided in parallel between the pair of reflectors and include a comb tooth-shaped electrode;
an amplifier circuit to which the pair of IDTs are connected in parallel; and
a switching circuit that is provided between each of the pair of comb tooth-shaped electrodes composing either IDT of the pair of IDTs and the amplifier circuit, switches between the input side and output side of the amplifier circuit to be connected to each of the pair of electrodes, and connects the electrodes and the amplifier circuit.

2. The oscillation circuit according to claim 1, wherein the pair of IDTs are configured so that the crossing widths of the comb tooth-shaped electrodes are identical.

3. An electronic device, wherein the oscillation circuit according to either one of claims 1 and 2 is built in.
